Europäisches Patentamt

**European Patent Office**

Office européen des brevets

(11) Numéro de publication: **0 103 521**
A2

# DEMANDE DE BREVET EUROPEEN

(21) Numéro de dépôt: 83401771.7

(51) Int. Cl.³: **H 01 J 37/34, C 23 C 15/00**

(22) Date de dépôt: **09.09.83**

(30) Priorité: **10.09.82 FR 8215378**

(43) Date de publication de la demande: **21.03.84**
**Bulletin 84/12**

(84) Etats contractants désignés: **DE GB IT NL**

(71) Demandeur: **CENTRE NATIONAL DE LA RECHERCHE SCIENTIFIQUE (CNRS), 13 Quai Anatole France, F-75700 Paris (FR)**

(72) Inventeur: **Sella, Claude, 13, Avenue St. Lambert, F-92360 Meudon la Foret (FR)**
Inventeur: **Tran-Khanh, Vien, 15, Chemin des Bourdons, F-93220 Gagny (FR)**
Inventeur: **Martin, Jean-Claude, 25, rue Lavoisier, F-92190 Meudon (FR)**

(74) Mandataire: **Behaghel, Pierre et al, CABINET PLASSERAUD 84 rue d'Amsterdam, F-75009 Paris (FR)**

(54) Perfectionnements aux substrats revêtus d'une couche mince d'oxyde de platine, aux dispositifs d'obtention des substrats ainsi revêtus, et aux produits obtenus à partir de tels substrats revêtus.

(57) Pour revêtir un substrat (5) d'une couche mince (6) d'oxyde de platine pur, substance isolante et transparente, on a recours à un magnétron cylindrique comprenant des moyens (4) pour engendrer un champ magnétique axial et, dans une enceinte (1) contenant de l'oxygène raréfié, une cathode axiale (2) au moins revêtue de platine et une grille cylindrique (3) formant anode et entourant coaxialement la cathode de façon à réserver une zone annulaire B à l'extérieur de la grille et l'on place le substrat dans cette zone B de façon telle que sa face à revêtir par la couche mince soit à l'abri de l'impact des électrons. Cette mise à l'abri peut également être obtenue par une forme particulière donnée aux barreaux constituant la grille ou par la mise en place d'obstacles dans la zone B. Il suffit ensuite de chauffer la couche mince, localement ou non, à plus de 250°C, pour la transformer en platine conducteur et opaque.

<u>Perfectionnements aux substrats revêtus d'une couche mince d'oxyde de platine, aux dispositifs d'obtention des substrats ainsi revêtus, et aux produits obtenus à partir de tels substrats revêtus.</u>

L'invention concerne la technique des couches minces en oxyde de platine déposées sur des substrats par pulvérisation cathodique d'une cible en platine dans une atmosphère raréfiée d'oxygène.

De telles couches minces présentent un grand intérêt vu, d'une part, leur nature isolante de l'électricité et leur relative transparence et, d'autre part, la très grande facilité de leur transformation, localisée ou non, en platine, métal conducteur de l'électricité et opaque à la lumière, une telle transformation pouvant être obtenue par simple chauffage à une température supérieure à 250°C.

Dans les modes de réalisation actuellement connus, on n'est pas parvenu à réaliser de telles couches minces suffisamment pures pour pouvoir tirer parti de la possibilité signalée ci-dessus.

En effet, les électrons qui sont à l'origine de la pulvérisation cathodique et qui, à cet effet, forment un plasma par leurs chocs contre les atomes du gaz constituant l'atmosphère raréfiée, ne sont pas tous consommés par cette formation et les molécules d'oxyde de platine élaborées à partir des atomes de platine arrachés à la cible par les ions de ce plasma sont décomposées par le flux d'électrons résiduel, soit en vol, avant de parvenir sur le substrat, soit après leur arrivée sur ce substrat.

L'invention a pour but, surtout, de remédier à cet inconvénient, en supprimant l'influence néfaste qui vient d'être signalée du flux d'électrons résiduel, tout en conservant un flux d'électrons de densité suffisante au voisinage de la cathode pour assurer la formation d'un plasma intense dans cette zone ainsi qu'une pulvérisation cathodique efficace et en maintenant une accessibilité suffisante entre la cathode et le substrat pour les molécules d'oxyde de platine.

A cet effet, selon l'invention :

- on a recours à un magnétron comportant lui-même d'une part des moyens pour engendrer un champ magnétique et d'autre part, à l'intérieur d'une enceinte contenant de l'oxygène raréfié, une cathode s'étendant parallèlement au champ magnétique, cathode au moins recouverte d'une couche de platine, et une grille formant anode s'étendant parallèlement à la cathode, en regard de sa couche de platine, de façon à réserver à l'intérieur de l'enceinte une chambre située du côté, de la grille, opposé à celui où se trouve la cathode,

- et on place le substrat dans ladite chambre de façon telle que sa face à revêtir par la couche mince d'oxyde de platine se trouve à l'abri de l'impact des électrons qui,en provenance de la cathode, sont amenés à circuler dans cette chambre après avoir traversé la grille.

Dans des modes de réalisation préférés, on a recours en outre à l'une et/ou à l'autre des dispositions suivantes:

- le magnétron est cylindrique en ce sens que le champ magnétique s'étend selon un axe, que la cathode s'étend selon cet axe,que la grille anodique est cylindrique et entoure la cathode, coaxialement à celle-ci, et que la chambre dans laquelle est placé le substrat est annulaire et extérieure à la grille,

- la mise à l'abri de la face du substrat à revêtir est assurée en exposant cette face vers l'aval des trajectoires des électrons considérés,

- la mise à l'abri de la face du substrat à revêtir est assurée en plaçant dans la  chambre des obstacles opaques aux électrons considérés,

- les obstacles selon l'alinéa précédent sont des barreaux plats dont le plan moyen est perpendiculaire ou à peu près aux trajectoires des électrons considérés,

- la mise à l'abri de la face du substrat à revêtir est assurée en constituant la grille à l'aide de barreaux plats dont le plan moyen  est perpendiculaire ou à peu près aux trajectoires des électrons considérés.

L'invention concerne également les substrats revêtus d'une couche mince en oxyde de platine pur, et en particulier ceux pour lesquels le dépôt de cette couche mince est réalisé à l'aide d'un dispositif tel que défini ci-dessus.

Elle concerne enfin les produits obtenus à partir de tels substrats revêtus d'une couche mince en oxyde de platine pur, et en particulier :

- les substrats revêtus de circuits imprimés obtenus par chauffage localisé de ladite couche à plus de 250°C,

- les substrats revêtus d'une couche mince de platine amorphe obtenue par chauffage de la couche mince d'oxyde de platine à une température comprise entre 250 et 500°C,

- et les substrats revêtus d'une couche de platine cristallisé pur obtenue par chauffage de la couche mince d'oxyde de platine à une température comprise entre 800 et 1.100°C.

L'invention comprend, mises à part ces dispositions principales, certaines autres dispositions qui s'utilisent de préférence en même temps et dont il sera plus explicitement question ci-après.

Dans ce qui suit, l'on va décrire des modes de réalisation préférés de l'invention en se référant au dessin ci-annexé d'une manière bien entendu non limitative.

La figure 1, de ce dessin, montre en vue perspective un dispositif établi conformément à l'invention pour élaborer des couches minces en oxyde de platine pur.

La figure 2 montre schématiquement une partie du même dispositif selon une coupe transversale agrandie.

La figure 3 montre encore schématiquement une variante de ce dispositif selon une coupe transversale.

Le dispositif d'élaboration considéré est essentiellement constitué par un magnétron cylindrique comprenant :

- une enceinte à vide cylindrique 1 d'axe X, raccordée à des moyens de pompage non représentés propres à créer le vide dans cette enceinte,

- une cathode 2 constituée par une tige s'étendant selon l'axe X à l'intérieur de l'enceinte 1,

- une anode 3 constituée par une grille cylindrique entourant la cathode 2, coaxialement à celle-ci et disposée comme cette dernière à l'intérieur de l'enceinte 1 en la divisant en une zone centrale A intérieure à la grille et en une zone annulaire B extérieure à la grille,

- et au moins un enroulement électrique de révolution 4 propre à engendrer un champ magnétique H orienté selon l'axe X.

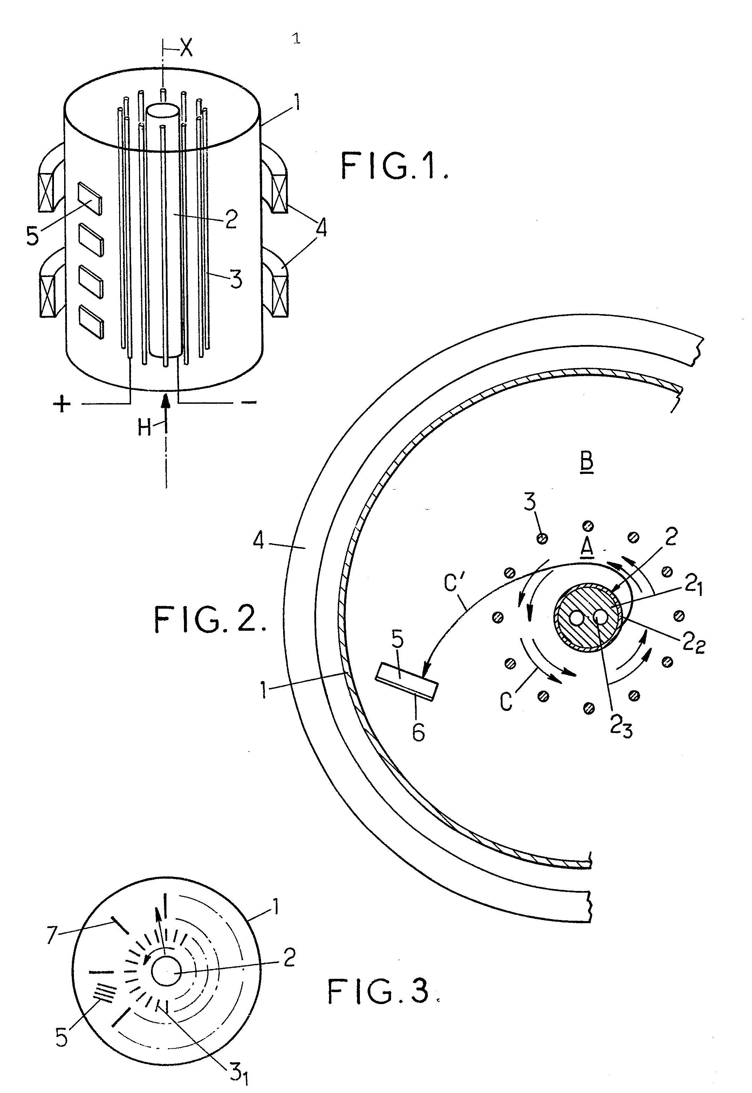

C'est dans la zone annulaire B que l'on place, conformément à l'invention, les substrats 5 à revêtir d'une couche mince 6 (figure 2) d'oxyde de platine en prenant soin de mettre la face, de chacun de ces substrats, destinée à être revêtue de la couche mince, à l'abri des électrons, ainsi qu'il sera précisé davantage plus loin.

L'enceinte 1 contient un gaz raréfié à base d'oxygène, gaz qui est avantageusement de l'oxygène pur ou un gaz rare (argon, krypton, xénon ...) mélangé avec de l'oxygène.

La cathode 2, destinée à faire fonction de cible, peut être constituée par une barre de platine mais elle est de préférence constituée par une barre $2_1$ d'un autre matériau conducteur de l'électricité, revêtue d'une couche ou feuille de platine $2_2$ et refroidie intérieurement par une circulation d'eau à travers des canaux $2_3$.

La grille anodique 3 est constituée par une couronne de barreaux parallèles.

Dans un tel appareil, les trajectoires des électrons qui sont déchargés par la cathode 2 en direction de l'anode 3 sont incurvées par le champ magnétique axial et décrivent, toutes dans le même sens, des orbites C d'allure cycloïdale autour de la cathode.

Le flux de ces électrons dans la zone centrale A, intérieure à la grille, est suffisamment intense pour former dans cette zone un plasma par chocs entre les électrons et les atomes du gaz raréfié.

Les ions positifs constitutifs de ce plasma bombardent la cible cathodique 2 et en arrachent des atomes de platine, lesquels sont projetés radialement vers l'extérieur et se combinent à l'oxygène environnant en formant des molécules d'oxyde de platine.

Ce sont celles, de ces molécules, qui parviennent à traverser le plasma et la grille anodique, qui forment le dépôt désiré en couche mince sur le substrat 5.

Mais l'orientation de la face, de ce substrat sur laquelle est effectué le dépôt considéré n'est pas indifférente.

En effet, si les électrons qui ont pu s'échapper de la zone centrale A à travers les barreaux de la grille 3, pour pénétrer dans la zone annulaire B, sont beaucoup moins nombreux que ceux circulant dans cette zone centrale, ils n'en exitent pas moins : ils décrivent encore dans la zone B des trajectoires C' d'allure cycloïdale, toutes orientées dans le même sens autour de l'axe X.

Du fait de la directivité de ce flux résiduel d'électrons, son influence sur le dépôt dépend de l'orientation de la face considérée du substrat.

Les inventeurs ont découvert que sur celle, de ces faces, qui n'est pas exposée à l'impact des électrons résiduels, le dépôt d'oxyde de platine est effectué sous la forme d'une couche mince 6 pure, stable et fortement adhérée sur ladite face : cette couche, colorée en jaune brun, est transparente à la lumière visible et très isolante électriquement, sa résistivité étant comprise entre 100 et 1.000 ohms.cm.

Au contraire, sur toutes les autres faces du substrat, les dépôts effectués sont constitués en définitive :

- ou bien par des mélanges de platine et d'oxyde de platine présentant l'aspect noir typique d'un cermet,

- ou bien par du platine pur d'aspect métallique.

Si en effet les molécules d'oxyde non dissociées "en vol" par un choc électronique parviennent indifféremment sur toutes les faces du substrat, seules celles parvenues sur la face, de ce substrat, "cachée" aux électrons résiduels, conservent leur intégrité.

En somme, la zone annulaire B est suffisamment "calme" en ce qui concerne la circulation des électrons pour que le bombardement par ces électrons de la couche mince en cours de formation puisse être supprimé purement et simplement par le choix judicieux adopté pour l'orientation de la face concernée du substrat, celle-ci "tournant le dos" aux électrons résiduels qui circulent dans ladite zone annulaire B.

On peut obtenir le même effet en réduisant l'importance de ce flux résiduel sans pour autant réduire le débit des projections radiales des molécules d'oxyde.

A cet effet par exemple, on donne aux barreaux de l'anode la forme de plaquettes ou ailettes $3_1$ (figure 3) s'étendant radialement ou selon des directions peu inclinées sur les directions radiales passant par leurs centres : une telle construction conduit en effet à un piégeage des électrons circulant selon des trajectoires cycloïdales alors qu'elle demeure totalement transparente aux projections radiales.

Le même effet peut être obtenu ou renforcé en disposant dans la zone annulaire B des masques 7 radiaux ou sensiblement radiaux, opaques aux électrons, ces masques étant avantageusement portés au même potentiel que l'anode 3.

Toutes mesures habituelles en matière de pulvérisation cathodique peuvent également être adoptées dans le cadre de la présente invention si elles sont à la fois avantageuses et compatibles avec celle-ci.

C'est ainsi que l'on pourra uniformiser les dépôts en montant les substrats sur des supports rotatifs et/ou en déplaçant les barreaux constitutifs de l'anode 3 autour de la cathode.

On donne ci-après, à titre purement illustratif, quelques précisions sur des modes de réalisation de l'invention ayant donné toute satisfaction :

- la pression du mélange oxygéné raréfié était de l'ordre de $10^{-2}$ millibar,

- la cathode 2 était portée à un potentiel de -3.000 V, alors que l'anode 3 était mise à la masse,

- le champ magnétique axial était compris entre 50 et 100 G,

- la cible était constituée par un chemisage de platine de 1 mm d'épaisseur rapporté sur un noyau cylindrique de cuivre présentant un diamètre de 5 cm et une longueur de 22 cm,

- la grille 3 était constituée par dix barreaux d'acier inoxydable formant une cage cylindrique de 15 cm de diamètre,

- les substrats 5, constitués en un matériau conducteur tel que le cuivre ou au contraire en un matériau isolant tel que le verre, étaient placés à des distances de la cible 2 comprises entre 10 et 15 cm et étaient alignés parallèlement les uns aux autres selon des colonnes parallèles à l'axe X,

- les couches minces 6 d'oxyde de platine obtenues présentaient une épaisseur de l'ordre de 0,1 à 0,2 μm.

En suite de quoi, on obtient avec le dispositif décrit ci-dessus des substrats revêtus de couches minces d'oxyde de platine particulièrement pures.

Comme indiqué plus haut, de telles couches présentent le grand avantage suivant : l'oxyde en question $PtO_2$ est à la fois optiquement transparent et très isolant électriquement et, pour le transformer de façon irréversible en platine, corps opaque à la lumière et conducteur de l'électricité, il suffit de chauffer cet oxyde à une température supérieure à 250°C.

Cette transformation irréversible se révèle particulièrement intéressante si on la localise avec précision en chauffant la couche mince selon un motif prédéterminé.

Un tel chauffage localisé peut être effectué à l'aide d'un faisceau laser, ou d'un faisceau d'électrons ou d'ions, ou encore par une projection quasi-instantanée sur la couche mince d'une image thermique formée par allumage d'une lampe flash séparée de cette couche par un masque localement transparent à la lumière, ou par un contact thermique assuré par application brève sur la couche mince d'une plaque chauffée, localement ajourée, pouvant à la limite être réduite à un simple fil.

Les produits résultants, lesquels comprennent des plages constituées alternativement en platine et en oxyde de platine selon un dessin particulier, demeurent stables jusqu'à une température supérieure à 200°C.

Ils se prêtent à de nombreuses applications, par exemple à la constitution de circuits imprimés conducteurs ou résistifs, ou encore à celle de mémoires optiques permanentes (vidéo-disques).

Par ailleurs, si la température de chauffage, qui est supérieure à 250°C, demeure inférieure à 500°C, le platine résultant de la réduction partielle de l'oxyde se trouve en son état amorphe, phase qui précipite dans la matrice subsistante dudit oxyde sous la forme de particules ultrafines présentant un diamètre de l'ordre de 20 Å : ce platine amorphe présente certaines caractéristiques avantageuses, en particulier dans le domaine de la catalyse ou dans celui de l'absorption d'énergie exploitant l'effet du corps noir (capteurs photo-thermiques).

Enfin, si la température du chauffage dépasse 500°C, le platine amorphe cristallise, toujours sous forme de grains ultrafins : vers 800°C, la décomposition de l'oxyde est totale, les grains de platine coalescent et l'on observe une cristallisation complète. Après un chauffage à environ 1.000°C suivi d'un lent refroidissement, on retrouve les propriétés électriques et optiques du platine massif pur. On dispose donc là d'un procédé permettant de revêtir un substrat d'une couche très mince de platine pur, ce qui peut conduire à de nombreuses applications intéressantes, telles que par exemple la fabrication de thermo-sondes

En suite de quoi, et quel que soit le mode de réalisation adopté, on dispose finalement d'une formule permettant d'obtenir des couches mince d'oxyde de platine pures, homogènes, stables et fortement adhérées sur leur substrat, et les substrats revêtus de telles couches minces peuvent conduire à la préparation de nombreux produits à propriétés intéressantes par simple chauffage, localisé ou non, de ces couches, à une température supérieure à 250°C.

Comme il va de soi, et comme il résulte d'ailleurs déjà de ce qui précède, l'invention ne se limite nullement à ceux de ses modes d'application et de réalisation qui ont été plus spécialement envisagés ; elle en embrasse, au contraire toutes les variantes, notamment :

- celles où le champ magnétique axial créé dans le magnétron cylindrique serait élaboré non pas à partir d'enroulements électriques annulaires extérieurs, mais à partir d'aimants permanents, disposés notamment à l'intérieur de la cathode, alors tubulaire,

- celles où le magnétron utilisé serait non pas d'un type cylindrique de révolution, comme celui décrit ci-dessus, mais d'un type "planar", cas dans lequel la cathode se présente sous la forme d'une plaque, le champ magnétique étant créé dans cette plaque, parallèlement à l'une des deux grandes dimensions de celle-ci, et la grille anodique étant plane et parallèle à ladite plaque.

REVENDICATIONS

1. Substrat revêtu d'une couche mince, caractérisé en ce que cette couche mince est une couche en oxyde de platine $PtO_2$ pur.

2. Dispositif pour préparer un substrat (5) revêtu d'une couche mince (6) d'oxyde de platine pur selon la revendication 1, caractérisé en ce qu'il comprend un magnétron comportant lui-même d'une part des moyens (4) pour engendrer un champ magnétique et d'autre part, à l'intérieur d'une enceinte (1) contenant de l'oxygène raréfié, une cathode (2) s'étendant parallèlement au champ magnétique, cathode au moins recouverte d'une couche de platine, et une grille (3) formant anode s'étendant parallèlement à la cathode, en regard de sa couche de platine, de façon à réserver à l'intérieur de l'enceinte une chambre (B) située du côté, de la grille, opposé à celui où se trouve la cathode, et en ce que le substrat est placé dans ladite chambre de façon telle que sa face à revêtir par la couche mince d'oxyde de platine se trouve à l'abri de l'impact des électrons qui, en provenance de la cathode, sont amenés à circuler dans cette chambre après avoir traversé la grille.

3. Dispositif selon la revendication 2, caractérisé en ce que le magnétron est cylindrique en ce sens que le champ magnétique s'étend selon un axe (X), que la cathode (2) s'étend selon cet axe, que la grille anodique (3) est cylindrique et entoure la cathode, coaxialement à celle-ci, et que la chambre (B) dans laquelle est placé le substrat est annulaire et extérieure à la grille.

4. Dispositif selon l'une quelconque des revendications 2 et 3, caractérisé en ce que la mise à l'abri de la face du substrat (5) à revêtir est assurée en exposant cette face vers l'aval des trajectoires (C') des électrons considérés.

5. Dispositif selon l'une quelconque des revendications 3 et 4, caractérisé en ce que la mise à l'abri de la face du substrat (5) à revêtir est assurée en plaçant dans la chambre (B) des obstacles (7) opaques aux électrons considérés.

6. Dispositif selon la revendication 5, caractérisé en ce que les obstacles (7) sont des barreaux plats dont le plan moyen est perpendiculaire ou à peu près aux trajectoires des électrons considérés.

7. Dispositif selon l'une quelconque des revendications 2 à 6, caractérisé en ce que la mise à l'abri de la face du substrat (5) à revêtir est assurée en constituant la grille à l'aide de barreaux plats ($3_1$) dont le plan moyen est perpendiculaire ou à peu près aux trajectoires des électrons considérés.

8. Substrat revêtu d'une couche mince en oxyde de platine selon la revendication 1, caractérisé en ce que cette couche à été déposée à l'aide d'un dispositif selon l'une quelconque des revendications 2 à 7.

9. Substrat revêtu d'un circuit imprimé à plages alternativement constituées en platine et en oxyde de platine pur, caractérisé en ce que ce circuit a été obtenu par chauffage localisé, à une température supérieure à 250°C, de la couche mince d'oxyde de platine pur déposée sur un substrat selon l'une quelconque des revendications 1 et 8.

10. Substrat revêtu d'une couche mince de platine amorphe, caractérisé en ce que cette couche a été obtenue par chauffage à une température comprise entre 250 et 500°C de la couche mince d'oxyde de platine pur déposée sur un substrat selon l'une quelconque des revendications 1 et 8.

11. Substrat revêtu d'une couche mince de platine cristallisé pur, caractérisé en ce que cette couche a été obtenue par chauffage à une température comprise entre 800 et 1.100°C de la couche mince d'oxyde de platine pur déposée sur un substrat selon l'une quelconque des revendications 1 et 8.

0103521

FIG.1.

FIG.2.

FIG.3.